# EUROPEAN PATENT APPLICATION

(11) **EP 4 808 291 A1**
(43) Date of publication of application: **16.09.2026**
(21) Application number: 25886649.0
(22) Date of filing: 29.10.2025
(51) Int. Cl.: H05K 3/00, H05K 3/28, H05K 3/06, H05K 1/03, C03C 15/00

(54) **GLASS SUBSTRATE SINGULATION PROCESS AND GLASS SUBSTRATE UNIT MANUFACTURED THEREBY**

(30) Priority: 31.10.2024 KR 20240152434; 28.10.2025 KR 20250157570
(71) Applicant: LG Chem, Ltd., Seoul 07336 (KR)
(72) Inventor: JUNG, Dae Chul, Seoul 07796 (KR); KWON, Oh Tak, Seoul 07796 (KR); RYU, Sanguk, Seoul 07796 (KR); YOO, Sangmoon, Seoul 07796 (KR); LEE, Chang Hee, Seoul 07796 (KR); CHOI, A Nam, Seoul 07796 (KR)
(74) Representative: Goddar, Heinz J.
(86) International application number: PCT/KR2025/017449
(87) International publication number: WO 2026/095614

(57) **Abstract**

An exemplary embodiment of the present disclosure provides a glass core substrate singulation process including the steps of: forming a metal pattern on one surface or both surfaces of a glass core substrate; forming an insulating layer on one surface or both surfaces of the glass core substrate on which the metal pattern is formed; removing the insulating layer formed on the metal pattern from the insulating layer; forming a protective layer on the insulating layer; removing the metal pattern; and cutting the glass core substrate along the position where the metal pattern of the glass core substrate is removed to form a glass core substrate unit.

## Description

### [Technical Field]

The present disclosure relates to a glass core substrate singulation process and a glass core substrate unit obtained therefrom.

The present application claims the benefit of Korean Patent Application No. 10-2024-0152434 filed on October 31, 2024 and Korean Patent Application No. 10-2025-0157570 filed on October 28, 2025, in the Korean Intellectual Property Office, the entire disclosure of which is incorporated herein by reference.

### [Background Art]

Glass core substrates, which are in the spotlight as materials for next-generation packages, are excellent in terms of warpage and coefficient of thermal expansion (CTE) as compared to conventional organic substrates, and thus enable realization of large-area substrates, and are very advantageous for high-speed signaling and heat dissipation through an increase in I/O number.

However, in the case of glass core substrates, when they are subjected to singulation into units, after the completion of a lamination process, through mechanical sawing used for conventional printed circuit boards, a problem of glass damage occurs.

To solve the above-mentioned problem, studies have been conducted about processes of directly cutting glass core substrates by using laser, but there is a problem in that micro-cracking occurs on the cut surface of a glass core substrate, and such a problem has not been solved yet.

Therefore, there is a need for technologies capable of chemical singulation of glass core substrates while not applying thermal and physical shock thereto.

### [References]

(Patent Document 1) Korean Patent Laid-Open No. 10-2011-0060622

### [Disclosure]

### [Technical Problem]

The present disclosure is directed to providing a glass core substrate singulation process and a glass core substrate unit obtained therefrom.

### [Technical Solution]

An exemplary embodiment of the present disclosure provides a glass core substrate singulation process including the steps of: forming a metal pattern on one surface or both surfaces of a glass core substrate; forming an insulating layer on one surface or both surfaces of the glass core substrate on which the metal pattern is formed; removing the insulating layer formed on the metal pattern from the insulating layer; forming a protective layer on the insulating layer; removing the metal pattern; and cutting the glass core substrate along the position where the metal pattern of the glass core substrate is removed to form a glass core substrate unit.

The metal pattern may be a Cu pattern.

The insulating layer may be Ajinomoto Build-up Film (ABF).

The step of removing the insulating layer formed on the metal pattern from the insulating layer may be a step of exposing at least a part of the metal pattern.

The step of removing the insulating layer formed on the metal pattern from the insulating layer may be a step of removing the insulating layer formed on the metal pattern by using CO₂ laser or UV laser.

The protective layer may be formed by using a positive photosensitive material or a negative photosensitive material.

In the step of forming a protective layer on the insulating layer, no protective layer may be formed on at least a part of the metal pattern.

The step of removing the metal pattern may be a step of exposing the glass core substrate by etching the metal pattern with a metal etching solution.

The step of cutting the glass core substrate along the position where the metal pattern of the glass core substrate is removed to form a glass core substrate unit may include the steps of: irradiating glass-modifying laser to the position where the metal pattern of the glass core substrate is removed; and dividing the glass core substrate into a plurality of glass core substrate units by etching the glass core substrate.

The glass-modifying laser may be Bessel beams.

The step of dividing the glass core substrate into a plurality of glass core substrate units by etching the glass core substrate may include a step of etching the glass core substrate by using a glass etching solution at a vertical etching rate of 3 µm/min or more.

The glass core substrate singulation process may further include a step of removing the protective layer from the glass core substrate unit.

An exemplary embodiment of the present disclosure provides a glass core substrate unit obtained by the above-described glass core substrate singulation process.

An exemplary embodiment of the present disclosure provides a glass core substrate unit including: a first plane and a second plane facing each other; a first lateral surface connected to the first plane and inclined; and a second lateral surface connected to the second plane and inclined, wherein the first lateral surface and the second lateral surface meet roundly at the center of the thickness of the glass core substrate unit, and the first lateral surface has a surface roughness (Ra) of 0.1 µm to 10 µm.

The first lateral surface has a taper angle of 50° to 70°, and the taper angle of the first lateral surface may be an angle between the surface perpendicular to the first plane and the first lateral surface.

### [Advantageous Effects]

A glass core substrate singulation process according to an exemplary embodiment of the present disclosure causes no micro-cracking on the cut surface of the glass core substrate when forming a glass core substrate unit, and the cut surface forms a proper taper angle, thereby avoiding a need for an edge grinding process.

A glass core substrate singulation process according to an exemplary embodiment of the present disclosure allows fabrication of glass core substrate units with no damage upon the insulating layer.

A glass core substrate unit according to an exemplary embodiment of the present disclosure has an round edge, thereby reducing a possibility of damages caused by an external shock and improving durability.

### [Brief Description of Drawings]

FIG. 1 shows a glass core substrate singulation process according to the related art.
FIG.2 to FIG. 5 illustrate problems of a singulation process according to the related art.
FIG. 6a to FIG. 6b show a glass core substrate singulation process according to an exemplary embodiment of the present disclosure.
FIG. 7 shows arrangement of a metal pattern according to an exemplary embodiment of the present disclosure.
FIG. 8 is a perspective view of a glass core substrate unit according to an exemplary embodiment of the present disclosure.
FIG. 9 is a sectional view of the edge portion of a glass core substrate unit according to an exemplary embodiment of the present disclosure.
FIG. 10 to FIG. 14 illustrate a cut surface observed after carrying out glass core substrate singulation according to Examples of the present disclosure.

### [Description of drawing numerals]

- 10:: Glass core substrate
- 11:: Metal pattern
- 20:: Insulating layer
- 21:: Laser for cutting insulating layer
- 30:: Protective layer
- 31:: Laser for modifying inner part of glass core substrate
- 100:: Glass core substrate unit

### [Best Mode]

Hereinafter, the present disclosure will be explained in more detail.

Throughout the present specification, when a part is described to "include" a component, this does not exclude the presence of another component but rather implies that further components may be included, unless the context specifically states otherwise.

Throughout the present specification, "from A to B" or "A-B" refers to a range of equal to or more than A and equal to or less than B.

Throughout the present specification, 'surface' of an object or 'on' an object may refer to any portion where the object is in contact with the outside.

In the present disclosure, a first direction DR1, a second direction DR2 and a third direction DR3 are defined in the accompanying drawings. The first direction DR1 and the second direction DR2 may be present on the same plane and may be perpendicular to each other. The first direction DR1 and the third direction DR3 may be present on the same another plane and may be perpendicular to each other. The second direction DR2 and the third direction DR3 may be present on the same still another plane and may be perpendicular to each other. The first direction DR1 may refer to the transverse direction on the drawings, and the second direction DR2 may refer to the longitudinal direction on the drawings. The third direction DR3 may refer to the up and down direction, i.e. thickness direction, on the drawings. The first direction to the third direction DR1, DR2, DR3 are based on what are represented on the drawings and may be relative. In the present disclosure, unless otherwise stated, 'direction' may refer to all directions toward both sides extended along the direction. In addition, when it is required to differentiate both 'directions' extended toward both sides, one side may be referred to as 'one side of the direction' and the other side may be referred to as 'the other side of the direction' separately. The direction indicated by the arrow pointing to the direction may be one side, and the opposite direction may be the other side.

Hereinafter, for the convenience of description, in explaining the surfaces of each member, one surface facing one side of the third direction DR3 may be referred to as the top surface, and the surface opposite to the above-mentioned one surface may be referred to as the lower surface or bottom surface. However, this is not restrictive, and one surface and the other surface of the member may be referred to as the front surface and back surface, or the first surface and the second surface, respectively. In addition, in explaining the relative position of each member, one side of the third direction DR3 may be referred to as the upper portion, and the other side of the third direction DR3 may be referred to as the lower portion. Such terms as 'upper portion', 'lower portion', up' and 'down' are relative concepts and are described based on the directions represented on the drawings.

In an exemplary embodiment of the present disclosure, there is provided the above-described glass core substrate singulation process.

In the glass core substrate singulation process according to an exemplary embodiment of the present disclosure, a metal pattern is formed on a zone where the singulation of the glass core substrate occurs to prevent the glass core substrate from being damaged upon the removal of the insulating layer, and a protective layer is formed on the insulating layer to prevent the insulating layer from being damaged upon the etching of the glass core substrate.

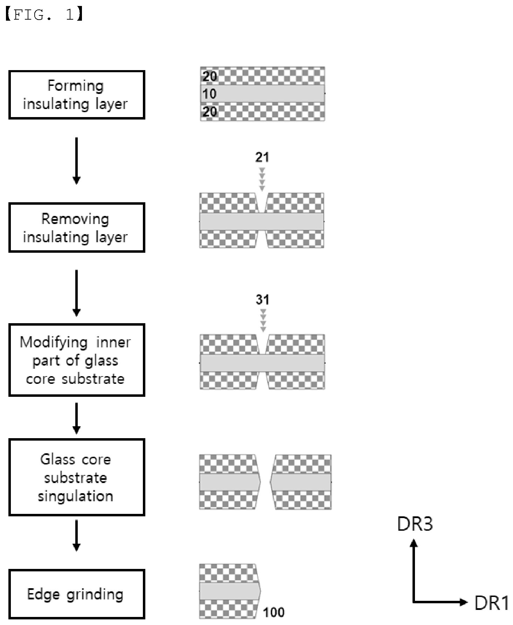

FIG. 1 shows a glass core substrate singulation process according to the related art, wherein an insulating layer 20 is formed on both surfaces of a glass core substrate 10, and the insulating layer 20 formed on the zone where the glass core substrate 10 is etched is removed by using laser 21 for removing an insulating layer. Herein, micro-cracking may occur on the glass core substrate 10 due to the laser 21. Then, the inner part of the glass core substrate 10 is subjected to phase shift by using laser 31 for modifying the inner part of a glass core substrate, and the glass core substrate 10 is etched to carry out singulation of the glass core substrate 10. However, in the case of the process according to the related art, the cut portion is not smooth due to cracks, etc., and thus a glass core substrate unit 100 is obtained through an additional edge grinding process.

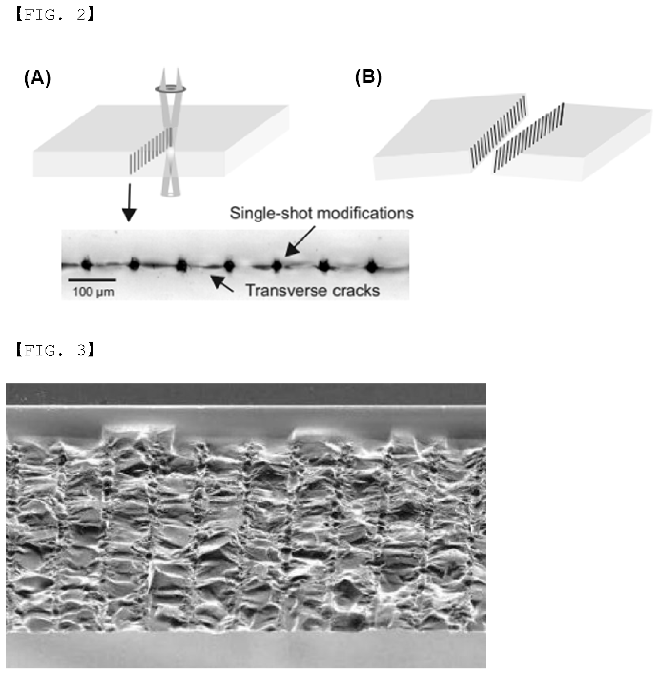

Specifically, FIG. 2 shows a singulation process using Bessel beams according to the related art. Holes are formed on a glass core substrate along the position to be cut as shown in (A) of FIG. 2, while inducing cracking of glass in the transverse direction at the same time, and then the substrate is cut physically to obtain a glass core substrate unit as shown in (B) of FIG. 2. When the glass core substrate is cut as mentioned above, the cut surface of the glass core substrate is the same as shown in FIG. 3 and has high surface roughness and a plurality of cracks.

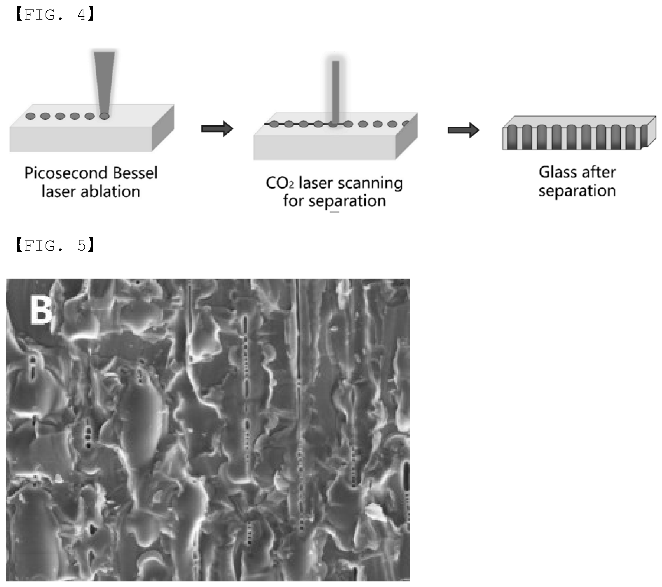

In addition, FIG. 4 shows a singulation process according to the related art, wherein a glass core substrate is subjected to laser ablation by using Bessel beams to form holes, and then a gap between one hole and another hole is cut by using CO₂ laser to divide the substrate. When the glass core substrate is cut in the above-mentioned manner, the cut surface is the same as shown in FIG. 5 and is also problematic in that it has high surface roughness and a plurality of cracks.

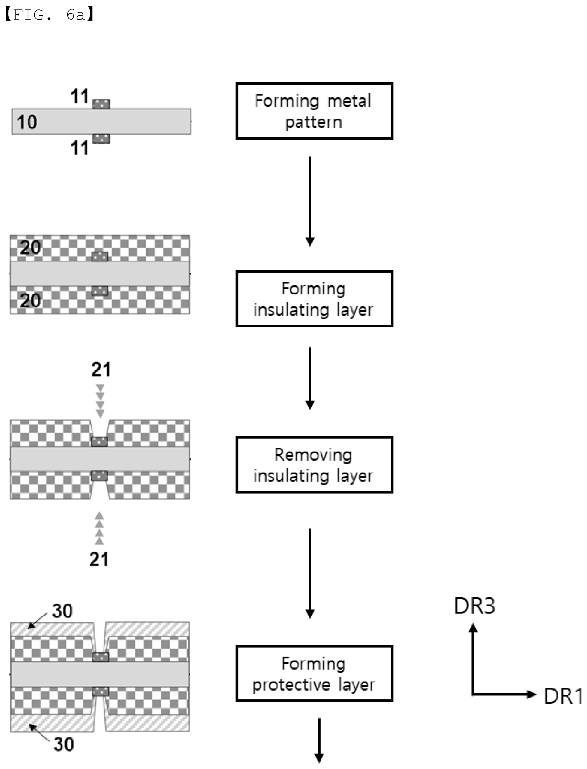

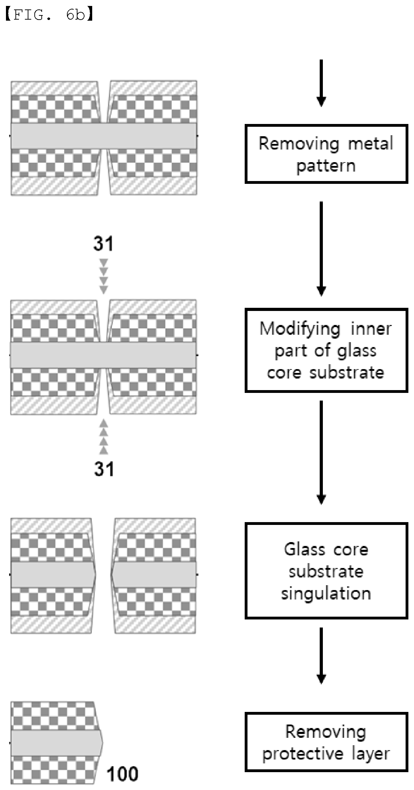

FIG. 6a and FIG. 6b are flow charts illustrating a glass core substrate singulation process according to the present disclosure. The process is characterized in that a metal pattern 11 is formed on a glass core substrate 10 before forming an insulating layer 20. By forming the metal pattern 11, the glass core substrate 10 can be prevented from being damaged by laser 21 used in a step of removing the insulating layer 20. In addition, a protective layer 30 is formed on the insulating layer 20 after removing the insulating layer 20, and thus the insulating layer 20 can be prevented from being damaged in the subsequent step of glass core substrate singulation. After forming the protective layer 30, the metal pattern 11 is removed, the inner part of the glass core substrate 10 is subjected to phase shift by using laser 31 for modifying the inner part of a glass core substrate, and the glass core substrate 10 is etched to perform singulation. Finally, the protective layer 30 is removed to obtain a glass core substrate unit 100. In the glass core substrate unit 100 according to the present disclosure, no cracking occurs on the cut surface, and thus there is no need for carrying out an additional edge grinding process.

The glass core substrate singulation process according to an exemplary embodiment of the present disclosure includes the steps of: forming a metal pattern on one surface or both surfaces of a glass core substrate; forming an insulating layer on one surface or both surfaces of the glass core substrate on which the metal pattern is formed; removing the insulating layer formed on the metal pattern from the insulating layer; forming a protective layer on the insulating layer; removing the metal pattern; and cutting the glass core substrate along the position where the metal pattern of the glass core substrate is removed to form a glass core substrate unit.

In an exemplary embodiment of the present disclosure, the glass core substrate may include a plurality of through-holes called through-glass via (TGV).

In an exemplary embodiment of the present disclosure, the glass core substrate may have a thickness of 0.3 mm to 1.2 mm.

In an exemplary embodiment of the present disclosure, the metal pattern formed on one surface or both surfaces of the glass core substrate may have a thickness of 0.05 µm to 0.5 µm.

Formation of the metal pattern within the above-defined range of thickness is effective for protecting the glass core substrate. When the metal pattern has a thickness of smaller than the above-defined range, damages or cracks may be generated on the glass core substrate surface by the UV laser used for removing the insulating layer. When the metal pattern has a thickness of larger than the above-defined range, it may affect the adhesion and planarization upon the adhesion of the insulating layer.

In an exemplary embodiment of the present disclosure, the metal pattern formed on one surface or both surfaces of the glass core substrate may have a width of 0.1 µm to 5 µm. The length of the metal pattern may be formed according to the singulation length.

In an exemplary embodiment of the present disclosure, the step of forming a metal pattern includes forming a metal pattern into the shape of a singulation pattern on one surface or both surfaces of the glass core substrate.

In an exemplary embodiment of the present disclosure, the singulation pattern is formed to cover the position where singulation occurs. The singulation pattern may be a cutting position of glass. The singulation pattern or metal pattern may be formed to surround the glass core substrate unit.

In an exemplary embodiment of the present disclosure, the glass core substrate unit may have a rectangular or trapezoidal shape, but is not limited thereto.

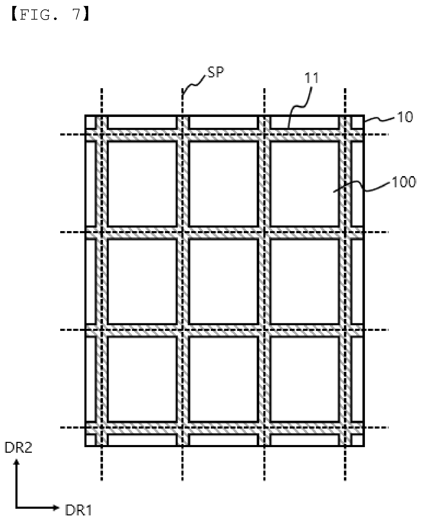

Referring to FIG. 7, in order to divide a glass core substrate 10 into a plurality of glass core substrate units 100, a singulation pattern SP is designed, and a metal pattern 11 is formed so that it may be overlapped with the singulation pattern SP.

The metal pattern may be formed by using a photoresist. After electroless plating ensuring adhesion is formed on the surface of the glass core substrate, a dry film is applied, and exposure and development are carried out. Then, the metal is etched at a partial zone by using an etchant, and the dry film is peeled to form a metal pattern according to the pattern to be subjected to singulation.

In an exemplary embodiment of the present disclosure, the metal pattern may be a Cu pattern.

When using a Cu pattern as a metal pattern, it is possible to prevent the glass core substrate from being damaged upon the removal of the insulating layer. When using a Ti/Cu pattern as a metal pattern, hydrofluoric acid-based ions should be used essentially in order to remove Ti during the formation of a pattern, but this is not preferred since the glass core substrate may be damaged by hydrofluoric acid-based ions.

In an exemplary embodiment of the present disclosure, the metal pattern may be formed on both surfaces (top surface and bottom surface) of the glass core substrate.

After forming the metal pattern on one surface or both surfaces of the glass core substrate, an insulating layer may be formed on the glass core substrate. Herein, the insulating layer may be formed so that it may cover the metal pattern.

In an exemplary embodiment of the present disclosure, the insulating layer may be a single layer or multiple layers. The insulating layer may have a multilayer structure. The insulating layer may include a via hole, and metal may be disposed in the via hole. For example, the insulating layer may be Ajinomoto build-up Film (ABF).

In an exemplary embodiment of the present disclosure, the insulating layer may have a thickness of 3 µm to 200 µm. In an exemplary embodiment of the present disclosure, the insulating layer may have a thickness of 3 µm to 30 µm. When the insulating layer is formed within the above-defined range of thickness, it is possible to carry out a build-up process efficiently.

In an exemplary embodiment of the present disclosure, the step of forming an insulating layer may include: a step of laminating an insulating layer film on one surface or both surfaces of the glass core substrate on which the metal pattern is formed; via-forming step; desmearing step; and a step of carrying out curing after metal pattern processing.

After forming the insulating layer, a partial zone of the insulating layer may be removed. The insulating layer is removed at the zone overlapped with the metal pattern, and the metal pattern may be at least partially exposed. The insulating layer may be removed at least partially from the zone overlapped with the metal pattern, or the insulating layer may be removed totally from the zone overlapped with the metal pattern. At the zone where the insulating layer is removed, the insulating layer is removed completely in the thickness direction. Through this step, the insulating layer may be patterned according to the shape of a glass core substrate unit.

In an exemplary embodiment of the present disclosure, the step of removing the insulating layer formed on the metal pattern from the insulating layer may be a step of removing the insulating layer formed on the metal pattern by using CO₂ laser or UV laser.

In an exemplary embodiment of the present disclosure, the CO₂ laser or UV laser is not particularly limited, as long as it is one used in the art.

In an exemplary embodiment of the present disclosure, UV laser may be used in the step of removing the insulating layer formed on the metal pattern from the insulating layer.

The glass core substrate singulation process according to an exemplary embodiment of the present disclosure is advantageous in that the glass core substrate is not damaged upon the removal of the insulating layer, since the metal pattern is formed at the zone where the insulating layer is removed.

After removing a partial zone of the insulating layer, a protective layer may be formed.

In an exemplary embodiment of the present disclosure, the protective layer may be formed by using a positive photosensitive material or a negative photosensitive material.

In an exemplary embodiment of the present disclosure, the positive photosensitive material or the negative photosensitive material is not limited to any particular type, and any material used in the art may be used.

In an exemplary embodiment of the present disclosure, the protective layer may have a thickness of 1 µm or more. When the protective layer is laminated to a thickness of 1 µm or more, it is possible to protect the insulating layer (ABF) from an etching solution.

In an exemplary embodiment of the present disclosure, the protective layer may have a thickness of 1 µm to 5 µm.

In an exemplary embodiment of the present disclosure, the protective layer may have a thickness of 1 µm to 2 µm.

In an exemplary embodiment of the present disclosure, the step of forming a protective layer on the insulating layer may be carried out by applying a protective layer composition onto the surface of the insulating layer, and then carrying out prebaking, exposure and development to form a protective layer.

In an exemplary embodiment of the present disclosure, the protective layer composition may include a positive photosensitive material or a negative photosensitive material.

In an exemplary embodiment of the present disclosure, the protective layer is formed on the surface of the insulating layer, and no protective layer is formed on at least a part of the metal pattern. Even after forming the protective layer, the metal pattern is at least partially exposed.

After forming the protective layer, the metal pattern may be removed.

In an exemplary embodiment of the present disclosure, the step of removing the metal pattern may be a step of exposing the glass core substrate by etching the metal pattern with a metal etching solution. The glass core substrate on the singulation pattern may be exposed.

In an exemplary embodiment of the present disclosure, the step of etching the metal pattern may be carried out through wet etching.

In an exemplary embodiment of the present disclosure, the step of etching the metal pattern may be carried out by applying a metal etching solution onto the metal pattern through spraying.

After removing the metal pattern, the glass core substrate may be cut along the position where the metal pattern is removed.

In an exemplary embodiment of the present disclosure, the step of cutting the glass core substrate along the position where the metal pattern of the glass core substrate is removed to form a glass core substrate unit may include the steps of: irradiating glass-modifying laser to the position where the metal pattern of the glass core substrate is removed; and dividing the glass core substrate into a plurality of glass core substrate units by etching the glass core substrate.

In an exemplary embodiment of the present disclosure, the glass-modifying laser can form a modified zone inside of the glass core substrate.

In an exemplary embodiment of the present disclosure, the glass-modifying laser may be Bessel beams.

In an exemplary embodiment of the present disclosure, the step of irradiating glass-modifying laser to the position where the metal pattern of the glass core substrate is removed may include modifying the phase inside of the glass core substrate by using Bessel beams before etching the glass core substrate.

In an exemplary embodiment of the present disclosure, the Bessel beams may use a wavelength of pico-second or more.

In an exemplary embodiment of the present disclosure, the Bessel beams may use a wavelength of IR-pico (1064 nm) or less.

In an exemplary embodiment of the present disclosure, the Bessel beams may use laser of 2 pico or less. When exceeding the above-defined range, phase shift efficiency may be lowered, or micro-cracking may occur.

In an exemplary embodiment of the present disclosure, before forming a glass core substrate unit by etching the glass core substrate, the inner part of the glass core substrate may be subjected to phase shift by forming a modified zone in the glass core substrate, thereby increasing the etching rate in the subsequent step of etching the glass core substrate.

In an exemplary embodiment of the present disclosure, the step of dividing the glass core substrate into a plurality of glass core substrate units by etching the glass core substrate may include a step of etching the glass core substrate by using a glass etching solution at a vertical etching rate of 3 µm/min or more.

In an exemplary embodiment of the present disclosure, the glass etching solution is not particularly limited but may include hydrofluoric acid.

In an exemplary embodiment of the present disclosure, the glass etching solution may further include an auxiliary etchant and an additive.

In an exemplary embodiment of the present disclosure, the step of etching the glass core substrate to form a glass core substrate unit may include a step of treating the glass core substrate to be etched with an etching solution through spraying.

In an exemplary embodiment of the present disclosure, the vertical etching rate means the etching rate in the thickness direction of the glass core substrate.

In an exemplary embodiment of the present disclosure, the vertical etching rate may be 3 µm/min to 10 µm/min.

In an exemplary embodiment of the present disclosure, the glass core substrate singulation process may further include a step of removing the protective layer from the glass core substrate unit. After removing the protective layer, the insulating layer may be exposed.

In an exemplary embodiment of the present disclosure, the step of removing the protective layer from the glass core substrate unit may be carried out by treatment with a peeling solution through spraying.

The glass core substrate singulation process according to an exemplary embodiment of the present disclosure can provide a glass core substrate unit having a smooth surface with no need for a grinding process of the cut surface after removing the protective layer.

Another exemplary embodiment of the present disclosure provides a glass core substrate unit. The glass core substrate unit can be obtained by the above-described glass core substrate singulation process.

The glass core substrate unit obtained according to an exemplary embodiment of the present disclosure includes no microcrack on the cut surface of the glass core substrate.

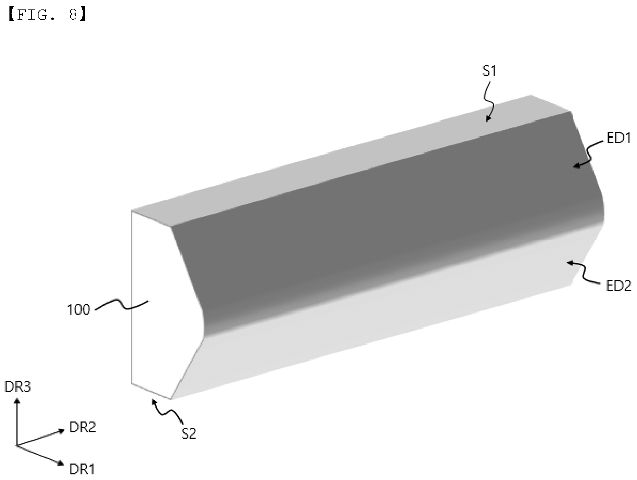

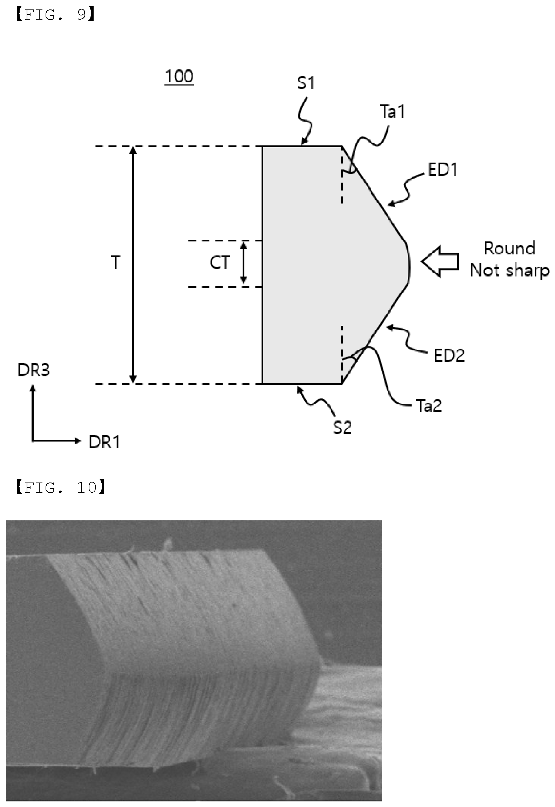

FIG. 8 is a perspective view of the edge portion of a glass cores substrate unit 100. The edge portion is a portion adjacent to the cut surface. FIG. 9 is a sectional view of the edge portion of a glass core substrate unit 100.

The glass core substrate 10 unit according to an exemplary embodiment of the present disclosure includes: a first plane S1 and a second plane S2 facing each other; a first lateral surface ED1 connected to the first plane S1 and inclined; and a second lateral surface ED2 connected to the second plane S2 and inclined.

The first plane S1 may be the top surface, the second plane S2 may be the bottom surface, and the first lateral surface ED1 and the second lateral surface ED2 may be cut surfaces.

Each of the first lateral surface ED1 and the second lateral surface ED2 is a part of the lateral surfaces of the glass core substrate unit 100, the first lateral surface ED1 may be the upper part in the thickness direction DR3, and the second lateral surface ED2 may be the lower part in the thickness direction DR3. The first lateral surface ED1 is inclined or slanted from the first plane S1 to the center of the thickness. The second lateral surface ED2 is inclined or slanted from the second plane S2 to the center of the thickness.

In an exemplary embodiment of the present disclosure, the first lateral surface ED1 and the second lateral surface ED2 meet roundly at the center CT of the thickness of the glass core substrate unit 100. The end portion of the edge portion where the first lateral surface ED1 and the second lateral surface ED2 meet each other is not sharp but has a round shape. Due to this, it is less likely that the glass core substrate unit 100 is damaged by external shock, and the glass core substrate unit has improved durability.

In an exemplary embodiment of the present disclosure, the center CT of the thickness of the glass core substrate unit 100 is a portion having a height corresponding to 0.45 to 0.55 times of the thickness T1 of the glass core substrate unit 100 from the second plane S2. In other words, the portion corresponding to between 45% and 55% of the height of the thickness T1 of the glass core substrate unit 100 from the second plane S2 is referred to as the center CT of the thickness of the glass core substrate unit 100.

In an exemplary embodiment of the present disclosure, the lateral surface of the glass core substrate unit 100 may include the round portion at the center CT of the thickness.

In an exemplary embodiment of the present disclosure, the first lateral surface ED1 of the glass core substrate unit 100 may be flat up to a height corresponding to less than 45% of the thickness T1 of the glass core substrate unit 100 from the first plane S1. At the portion except the center CT of the thickness, the first lateral surface ED1 is not round but flat.

In an exemplary embodiment of the present disclosure, the second lateral surface ED2 of the glass core substrate unit 100 may be flat up to a height corresponding to less than 45% of the thickness T1 of the glass core substrate unit 100 from the second plane S2. At the portion except the center CT of the thickness, the second lateral surface ED2 is not round but flat.

In an exemplary embodiment of the present disclosure, the round portion at the center CT of the thickness has a radius of curvature of 20 mm or less. When the glass core substrate unit 100 is viewed from the lateral surface, an imaginary circle including the round portion of the lateral surface is set, and then the radius of the imaginary circle may be defined as the size of round. For example, the round portion may have a radius of curvature of 5 mm to 20 mm.

In an exemplary embodiment of the present disclosure, the first lateral surface ED1 may have a surface roughness (Ra) of 0.1 µm to 10 µm.

In an exemplary embodiment of the present disclosure, the first lateral surface ED1 may have a surface roughness (Ra) of 0.1 µm to 5 µm.

In an exemplary embodiment of the present disclosure, the first lateral surface ED1 may have a surface roughness (Ra) of 0.1 µm to 1 µm.

In an exemplary embodiment of the present disclosure, the second lateral surface ED2 may have a surface roughness (Ra) of 0.1 µm to 10 µm.

In an exemplary embodiment of the present disclosure, the second lateral surface ED2 may have a surface roughness (Ra) of 0.1 µm to 5 µm.

In an exemplary embodiment of the present disclosure, the second lateral surface ED2 may have a surface roughness (Ra) of 0.1 µm to 1 µm.

In the present disclosure, the surface roughness (Ra) may be determined by the methods known to those skilled in the art. The surface roughness (Ra) may be determined according to ISO 4287, ISO 25178 or ASTM E1421. For example, the surface roughness of the glass core substrate unit 100 may be determined through the Ra-measuring mode of 3D confocal microscope available from Keyence Corp. according to ISO 25178. The surface roughness (Ra) of each of the first lateral surface ED1 and the second lateral surface ED2 may be determined at a flat position.

The first lateral surface ED1 and the second lateral surface ED2 of the glass core substrate unit 100 have a low surface roughness (Ra) and show high mechanical strength.

In an exemplary embodiment of the present disclosure, the first lateral surface ED1 has a taper angle Ta1 of 50° to 70°. The taper angle of the first lateral surface ED1 is an angle between the surface perpendicular to the first plane S1 and the first lateral surface ED1. When the taper angle falls within the above-defined range, there is no need for an additional edge grinding process.

In an exemplary embodiment of the present disclosure, the second lateral surface ED2 has a taper angle Ta2 of 50° to 70°. The taper angle of the second lateral surface ED1 is an angle between the surface perpendicular to the first plane S1 and the second lateral surface ED2. When the taper angle falls within the above-defined range, there is no need for an additional edge grinding process.

In an exemplary embodiment of the present disclosure, TGV holes are formed at the central portion of the glass core substrate unit 100, the TGV holes may have a taper angle different from the taper angle of the first lateral surface ED1. The TGV holes may have a taper angle different from the taper angle of the second lateral surface ED2. Formation of TGV holes and penetration for singulation are not carried out simultaneously.

In an exemplary embodiment of the present disclosure, the glass core substrate unit 100 may have a thickness T of 0.3 mm to 1.2 mm.

The glass core substrate unit obtained according to the present disclosure may be used for semiconductor packaging. Specifically, the glass core substrate unit according to the present disclosure maybe used for packaging semiconductor chips/devices. More specifically, semiconductor packaging is generally referred to as a post-processing technology including cutting a processed wafer into the shape of a chip and packaging the same. Herein, glass core substrates have been given many attentions as next-generation semiconductor packaging materials functioning to connect semiconductor chips physically/ electrically to a system. For the purpose of use as a semiconductor packaging material, functions, such as mechanical protection, electrical/mechanical connection and heat dissipation, are required. Particularly, in the case of a TGV hole substrate, a fine electrode path assisting electricity flow is contained in a glass core substrate, and thus there is an advantage in that a larger number of chips and high-performance chips can be mounted.

The glass core substrate unit obtained according to the present disclosure can be applied to the field of packaging requiring a large area, such as artificial intelligence (AI), high-performance computer (HPC), data center, server or networking, and particularly to generative AI and HPC.

### [Mode for Invention]

Hereinafter, the present disclosure is described in detail through examples. However, the examples according to the present disclosure may be changed into several different forms, and the scope of the present disclosure is not to be interpreted as being limited to the examples described below. The examples of the present specification are provided to describe the present disclosure more fully to those having ordinary knowledge in the art.

### <Example 1>

A glass core substrate having a thickness of 600 µm was prepared, both surfaces thereof were subjected to treatment for improving adhesion based on the position to be subjected to singulation, electroless Cu plating was carried out, and then patterning was formed with a positive photosensitive material. Then, Cu etching was carried out, and the photosensitive material was peeled to form a Cu pattern having a thickness of 0.05 µm and a width of 0.5 µm according to the position to be subjected to singulation.

After that, multilayer lamination and patterning processes using Ajinomoto Build-up Film (ABF) were carried out to a thickness of 7 µm to 200 µm on both surfaces of the glass core substrate, and the insulating layer formed at the position to be subjected to singulation was removed by using UV laser. A negative photosensitive material was applied to the surface of the insulating layer to form a protective layer to a thickness of 2 µm, and the Cu pattern was removed by using a metal etching solution. Then, phase shift was carried out at the position to be subjected to singulation on the surface of the substrate by using 400 femto-second laser with 38 µJ at an interval of 1 µm, and then both surfaces of the glass core substrate were treated with a glass etching solution through spraying for 30 minutes to perform singulation, and the protective layer was removed by using a dedicated peeling agent. Herein, the taper angle was 65°, and the first surface and the second surface had a surface roughness of 0.49 µm. The cut surface observed by using scanning electron microscopy (SEM) is shown in FIG. 10.

### <Example 2>

Formation of a Cu pattern, formation of an insulating layer, partial removal of the insulating layer and removal of the Cu pattern were carried out in the same manner as Example 1, except that a glass core substrate having a thickness of 1100 µm was used.

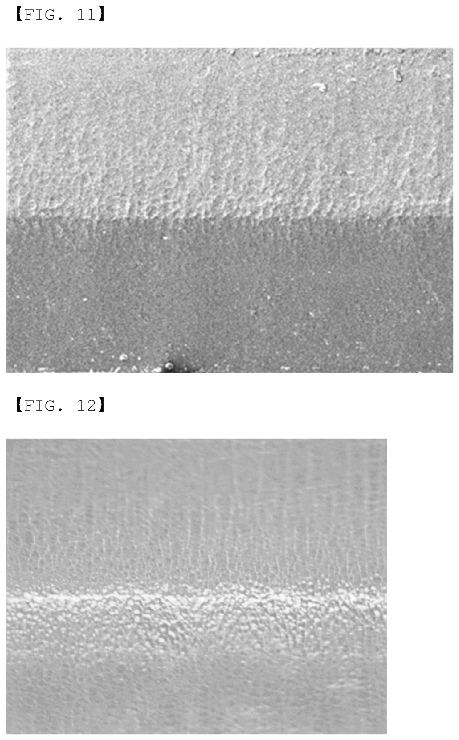

Then, laser phase shift was carried out at the position to be subjected to singulation on the surface of the substrate. Herein, the laser had a pulse width of 1 pico-second and a single pulse energy of 75 µJ, and the phase shift was carried out at an interval of 1.2 µm. The focus of the laser was set at a position of 100 µm. After that, both surfaces of the glass core substrate were treated by using a glass etching solution with Singulation End Point Detection (S-EPD) for 30 minutes to perform singulation (etch selection ratio: 2.96). The protective layer was removed by using a dedicated peeling agent. Herein, the taper angle was 60°, and the first surface and the second surface had a surface roughness of 0.8 µm. The cut surface observed by using scanning electron microscopy (SEM) is shown in FIG. 11 to FIG. 14.

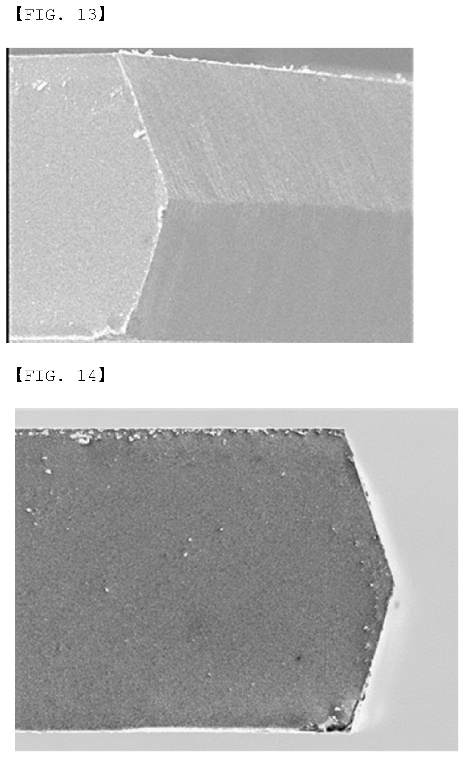

FIG. 11 is an SEM image illustrating the cut surface of the glass core substrate unit as viewed from the front side, FIG. 12 is an optical microscopic image of the central portion of the cut surface of the glass core substrate unit, FIG. 13 is an SEM image illustrating the edge portion of the glass core substrate unit as viewed obliquely, and FIG. 14 is an SEM image illustrating the glass core substrate unit as viewed from the lateral side. The SEM and optical microscopic images are taken at a magnification of 50 to 300 times. It can be seen from FIG. 14 that each of the first lateral surface and the second lateral surface has an taper angle of 60°. This suggests that no cracks are generated on the cut surface.

## Claims

1. A glass core substrate singulation process comprising the steps of:
forming a metal pattern on one surface or both surfaces of a glass core substrate;
forming an insulating layer on one surface or both surfaces of the glass core substrate on which the metal pattern is formed;
removing the insulating layer formed on the metal pattern from the insulating layer;
forming a protective layer on the insulating layer;
removing the metal pattern; and
cutting the glass core substrate along the position where the metal pattern of the glass core substrate is removed to form a glass core substrate unit.

2. The glass core substrate singulation process according to claim 1,
wherein the metal pattern is a Cu pattern.

3. The glass core substrate singulation process according to claim 1,
wherein the insulating layer is Ajinomoto Build-up Film (ABF).

4. The glass core substrate singulation process according to claim 1,
wherein the step of removing the insulating layer formed on the metal pattern from the insulating layer is a step of exposing at least a part of the metal pattern.

5. The glass core substrate singulation process according to claim 1,
wherein the step of removing the insulating layer formed on the metal pattern from the insulating layer is a step of removing the insulating layer formed on the metal pattern by using CO₂ laser or UV laser.

6. The glass core substrate singulation process according to claim 1,
wherein the protective layer is formed by using a positive photosensitive material or a negative photosensitive material.

7. The glass core substrate singulation process according to claim 1,
wherein no protective layer is formed on at least a part of the metal pattern, in the step of forming a protective layer on the insulating layer.

8. The glass core substrate singulation process according to claim 1,
wherein the step of removing the metal pattern is a step of exposing the glass core substrate by etching the metal pattern with a metal etching solution.

9. The glass core substrate singulation process according to claim 1,
wherein the step of cutting the glass core substrate along the position where the metal pattern of the glass core substrate is removed to form a glass core substrate unit comprises the steps of:
irradiating glass-modifying laser to the position where the metal pattern of the glass core substrate is removed; and
dividing the glass core substrate into a plurality of glass core substrate units by etching the glass core substrate.

10. The glass core substrate singulation process according to claim 9,
wherein the glass-modifying laser is Bessel beams.

11. The glass core substrate singulation process according to claim 9,
wherein the step of dividing the glass core substrate into a plurality of glass core substrate units by etching the glass core substrate comprises a step of etching the glass core substrate by using a glass etching solution at a vertical etching rate of 3 µm/min or more.

12. The glass core substrate singulation process according to claim 1, further comprising a step of removing the protective layer from the glass core substrate unit.

13. A glass core substrate unit obtained by the glass core substrate singulation process according to any one of claims 1 to 12.

14. A glass core substrate unit comprising:
a first plane and a second plane facing each other;
a first lateral surface connected to the first plane and inclined; and
a second lateral surface connected to the second plane and inclined,
wherein the first lateral surface and the second lateral surface meet roundly at the center of the thickness of the glass core substrate unit, and
the first lateral surface has a surface roughness (Ra) of 0.1 µm to 10 µm.

15. The glass core substrate unit according to claim 14,
wherein the first lateral surface has a taper angle of 50° to 70°, and
the taper angle of the first lateral surface is an angle between the surface perpendicular to the first plane and the first lateral surface.
